# EUROPEAN PATENT APPLICATION

(11) **EP 2 560 193 A1**
(43) Date of publication of application: **20.02.2013**
(21) Application number: 10849896.5
(22) Date of filing: 06.09.2010
(51) Int. Cl.: H01L 21/205

(54) **GAS INJECTION UNIT AND A THIN-FILM VAPOUR-DEPOSITION DEVICE AND METHOD USING THE SAME**

(30) Priority: 12.04.2010 KR 20100033318
(71) Applicant: Semes Co., Ltd., Cheonan-si, Chungcheongnam-do 330-290 (KR)
(72) Inventor: PARK, Hyeong Soo, Seoul 158-772 (KR)
(74) Representative: O'Neill, Michelle
(86) International application number: PCT/KR2010/006021
(87) International publication number: WO 2011/129492

(57) **Abstract**

Provided are a gas injection unit and apparatus and method for depositing a thin layer using the same. The gas injection unit includes: an inner pipe through which a reaction gas is introduced; an outer pipe enclosing the inner pipe, through which a cooling fluid cooling the reaction gas in the inner pipe flows; and injection pipes injecting the reaction gas in the inner pipe to an outside of the outer pipe.

## Description

### [Technical Field]

The present invention herein relates to a gas injection unit and apparatus and method for depositing a thin layer using the same, and more particularly, to a gas injection unit injecting a reaction gas and apparatus and method for depositing a thin layer using the same.

### [Background Art]

In a semiconductor device manufacturing process, many metal organic chemical vapor deposition (MOCVD) methods using a metal organic compound apparatus have been developed so as to form a variety of high quality layers. The MOCVD method is a process to deposit a metal layer on a substrate through a thermal decomposition reaction by vaporizing liquid state metal organic compound to generate metal organic vapor, supplying the generated metal organic vapor and a hydrogen compound gas to react with the generated metal organic vapor into the substrate on which a layer is being formed, and exposing the metal organic compound gas and the hydrogen compound gas to a high temperature.

Then, in the MOCVD process, when a gas injection member injecting reaction gases is exposed to a high temperature heat, non-intended reaction may occur due to the high temperature heat before the reaction gas is supplied to the substrate, a parasitic deposition may occur on the gas injection member. To this end, the reaction gas is not uniformly supplied to the substrate, so the quality of a deposited

### [Disclosure]

### [Technical Problem]

The present invention provides apparatus and method for depositing a thin layer with enhanced quality, and a gas injection unit used in the apparatus and method.
The purpose of the present invention is not limited above, and another purpose not mentioned in the description can be understood by a person having ordinary skill in the art from the blow description.

### [Technical Solution]

Embodiments of the present invention provide apparatuses for depositing a thin layer, including: a processing chamber; a substrate supporting unit disposed in the processing chamber to support the substrate; a heater heating the substrate supported by the substrate supporting unit; and a gas injection unit disposed over the substrate supporting unit in the processing chamber, wherein the gas injection unit includes: an inner pipe through which a reaction gas is introduced; an outer pipe enclosing the inner pipe, through which a cooling fluid cooling the reaction gas in the inner pipe flows; and injection pipes injecting the reaction gas in the inner pipe to an outside of the outer pipe.

In some embodiments, the gas injection unit may be disposed such that the length direction of the inner pipe and the outer pipe are toward an up and down direction.

In other embodiment, the substrate supporting unit may include: a supporting plate having a plate shape and formed with a plurality of first grooves accommodating a substrate holder in an edge region of an upper surface thereof along a circumferential direction; and a rotation driving member rotating the supporting plate, wherein the gas injection unit may be disposed over a central region of the supporting plate.

In still other embodiments, the supporting plate may be formed with a second groove in the central region of the upper surface of the supporting plate, and the outer pipe may be inserted into the second groove such that a lower end of the outer pipe is disposed spaced apart from a bottom surface of the second groove.

In even embodiments, the injection pipes may be provided in plurality along a circumferential direction of the inner pipe.

In yet embodiments, some of the injection pipes may be provided at heights different from each other.

In further embodiments, the injection pipes may be divided into a plurality of groups, the injection pipes which pertain to the same group may be provided at the same height of the inner pipe along the circumferential direction, and the injection pipes which pertain to different groups may be provided at different heights of the inner pipe along the circumferential direction.

In still further embodiments, the injection pipes which pertain to any one group of the plurality of groups may be provided to inject the reaction gas to a region adjacent to the supporting plate, and the injection pipes which pertain to another group of the plurality of groups may be provided to inject the reaction gas to a region adjacent to an upper wall of the processing chamber.

In even further embodiments, the gas injection unit may further include: a first gas inlet port provided to the inner pipe such that a first reaction gas is introduced; and a second gas inlet port provided to the inner pipe such that a second reaction gas is introduced.

In yet further embodiments, the gas injection unit may include: one gas inlet portion provided to the inner pipe; a main gas supply pipe connected to the gas inlet port; a first gas supply source connected to a first branch pipe branched from the main gas supply pipe to supply a first reaction gas; and a second gas supply source connected to a second branch pipe branched from the main gas supply pipe to supply a second reaction gas.

In other embodiments, the gas injection unit may include: a cooling fluid inlet port provided to the outer pipe such that the cooling fluid is introduced; and a cooling fluid outlet port provided to the outer pipe such that the cooling fluid is discharged.

In still other embodiments, the gas injection unit may further include a separation plate which partitions a space between the inner pipe and the outer pipe into a first region fluidly communicating with the cooling fluid inlet port, a second region fluidly communicating with the cooling fluid outlet port, and a third region fluidly communicating the first region and the second region with each other.

In even other embodiments, the inner pipe may include: a first inner pipe through which a first reaction gas is introduced; and a second inner pipe enclosing the first inner pipe, through which a second reaction gas is introduced, wherein the injection pipes may include: first injection pipes injecting the first reaction gas inside the first inner pipe to an outside of the outer pipe; and second injection pipes injecting the second reaction gas inside the second inner pipe to the outside of the outer pipe.

In yet other embodiments, the injection pipes may include: a cooling fluid inlet port provided to the outer pipe such that the cooling fluid is introduced; and a cooling fluid outlet port provided to the outer pipe such that the cooling fluid is discharged.

In further embodiments, the gas injection unit may further include a separation plate which partitions a space between the outer pipe and the second inner pipe into a first region fluidly communicating with the cooling fluid inlet port, a second region fluidly communicating with the cooling fluid outlet port, and a third region fluidly communicating the first region and the second region with each other.

In still further embodiments of the present invention, methods for depositing a thin layer, include: loading a substrate into a processing chamber; heating the substrate; and injecting a reaction gas onto the substrate, wherein the reaction gas may be introduced into an inner pipe of a gas injection unit, be cooled by a cooling fluid flowing through an outer pipe enclosing the inner pipe, and be injected onto the substrate through injection pipes connecting the inner pipe and the outer pipe.

In even further embodiments, the gas injection unit may be disposed such that the length direction thereof is toward an up and down direction, and the reaction gas may be injected onto the substrate through the injection pipes disposed in a horizontal direction.

In yet further embodiments, the substrate loaded may be in plurality, the plurality of substrates may be loaded on an edge region of a supporting plate in a circumferential direction, and the gas injection unit may inject the reaction gas over a central region of the supporting plate.

In other embodiments, the supporting plate may rotate a central axis thereof, and each of the plurality of substrates rotates on a central axis there.

In still other embodiments, the reaction gas may include a first reaction gas and a second reaction gas having a component different from the first reaction gas, wherein the first and second reaction gases may be independently introduced into the inner pipe and are then mixed with each other.

In even other embodiments, the reaction gas may include a first reaction gas and a second reaction gas having a component different from the first reaction gas, wherein the first and second reaction gases may be introduced into the inner pipe in a mixed state.

In yet other embodiments, the reaction gas may include a first reaction gas and a second reaction gas having a component different from the first reaction gas, the inner pipe may include a first inner pipe through which the first reaction gas is introduced, and a second inner pipe enclosing the first inner pipe, through which the second reaction gas is introduced, and the first reaction gas may be injected through first injection pipes connecting the first inner pipe and the outer pipe, and the second reaction gas may be injected through second injection pipes connecting the second inner pipe and the outer pipe.

In further embodiments of the present invention, gas injection units include: an inner pipe through which a reaction gas is introduced; an outer pipe enclosing the inner pipe, through which a cooling fluid cooling the reaction gas inside the inner pipe flows; and injection pipes injecting the reaction gas inside the inner pipe to an outside of the outer pipe.

In still further embodiments, the injection pipes may be provided in plurality along a circumferential direction of the inner pipe, the injection pipes may be divided into a plurality of groups, the injection pipes which pertain to the same group may be provided at the same height of the inner pipe along the circumferential direction, and the injection pipes which pertain to different groups may be provided at different heights of the inner pipe along the circumferential direction.

In even further embodiments, the above gas injection unit may further include: a first gas inlet port provided to the inner pipe such that the first reaction gas is introduced; and a second gas inlet port provided to the inner pipe such that the second reaction gas is introduced.

### [Advantageous Effects]

According to the present invention, an unintended reaction of the reaction gas can be prevented in advance by cooling down the reaction gas inside the inner pipe of the gas injection unit below a reaction temperature.

According to the present invention, a quality of the deposited thin metal layer can be improved.

### [Description of Drawings]

The purpose of hereinafter described drawings is to illustrate the present invention only, not to limit the scope of the present invention.

FIG. 1 is a schematic view illustrating a thin layer deposition apparatus according to an embodiment of the present invention;

FIG. 2 is a plane view illustrating the gas injection unit and the substrate supporting unit of FIG. 1;

FIG. 3 is an enlarged view illustrating the gas injection unit and the substrate supporting unit of FIG. 1;

FIG. 4 is a partial cutaway perspective view of a gas injection unit;

FIG. 5 is a plane sectional view of a gas injection unit;

FIG. 6 is a schematic view illustrating another embodiment of the gas injection unit of FIG. 3;

FIG. 7 is a schematic view illustrating another layout structure of the gas injection unit and the substrate supporting unit; and

FIGS. 8 and 9 are schematic views illustrating still another embodiment of the gas injection unit of FIG. 3.

### [Best Mode]

Exemplary embodiments of the inventive concept will be described below in more detail with reference to the accompanying drawings. It is noted that like reference numerals denote like elements in appreciating the drawings although the like elements are shown on different figures. Also, detailed descriptions related to well-known functions or configurations will be ruled out in order not to unnecessarily obscure subject matters of the present invention.

(Embodiment)

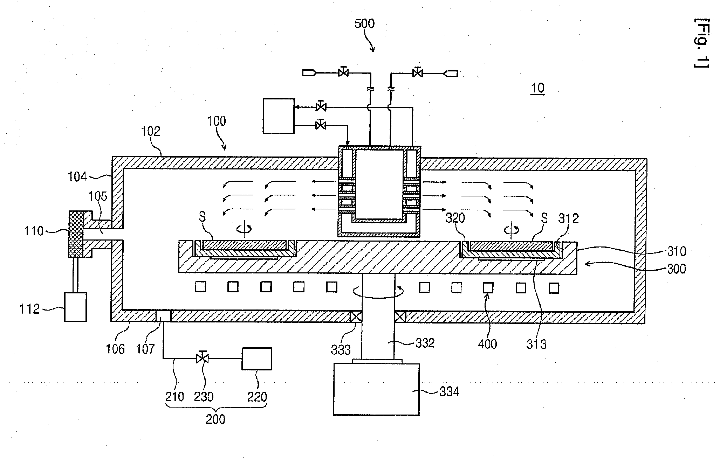

FIG. 1 is a schematic view illustrating a thin layer deposition apparatus 10 according to an embodiment of the present invention.

The thin layer deposition apparatus 10 deposits a thin layer on a substrate by using a metal organic chemical vapor deposition (MOCVD) method, i.e., by using a gas thermal decomposition reaction of a metal organic compound and a hydrogen compound. The substrate used in the thin layer deposition process may be a sapphire (Al2O3) substrate and a silicon carbide (SiC) substrate used in manufacturing an Epi wafer in the manufacturing process of an LED, a silicon wafer used in manufacturing a semiconductor integrated circuit (IC).

Referring to FIG. 1, the thin layer deposition apparatus 10 according to an embodiment of the present invention includes a processing chamber 100, a discharge unit 200, a substrate supporting unit 300, a heating unit 400, and a gas injection unit 500.

The processing chamber 100 provides a space where an MOCVD process is performed. The processing chamber 100 has an upper wall 102, a sidewall 104 extending downwardly from an edge of the upper wall 102, and a lower wall 106 coupled to a lower end of the sidewall 104. The upper wall 102 and the lower wall 106 may be provided in a circular plate shape. A passage 105 through which a substrate S is loaded/unloaded is formed in the sidewall 104 of the processing chamber 100. A door 110 opening and closing the passage 105 is installed at an entrance of the passage 105. The door 110 is coupled to a driver 112 and opens and closes the entrance of the passage 105 while moving in a direction vertical to the length direction of the passage 105 by an operation of the driver 112.

The discharge unit 200 includes a discharge line 210, a discharge member 220, and a valve 230. One end of the discharge line 210 is connected to a discharge hole 107 formed in the lower wall 106 of the processing chamber 100, and the other end of the discharge line 210 is connected to the discharge member 220. The discharge member 220 may be a pump to create a negative pressure inside the processing chamber 100. If the discharge member 220 creates a negative pressure inside the processing chamber 100, reaction product and carrier gas unnecessarily remaining inside the processing chamber 100 are discharged, and the inner pressure of the processing chamber 100 may be maintained at a process pressure through the discharge. The process pressure inside the processing chamber 100 may have various ranges, for example, a range of a low vacuum pressure of several Torr to the atmospheric pressure of 760 Torr. The valve 230 is disposed on the discharge line 210 between the discharge hole 107 and the discharge member 220 to open and close flow of a reaction product and a carrier gas through an inner space of the discharge line 210.

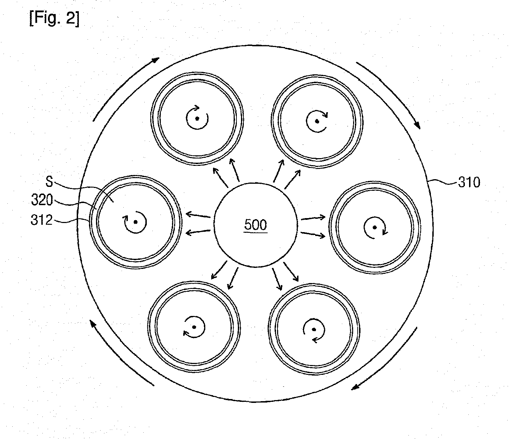

FIG. 2 is a plane view of the gas injection unit and the substrate supporting unit of FIG. 1. Referring to FIGS. 1 and 2, the substrate supporting unit 300 is disposed inside the processing chamber 100 to support the substrate S. The substrate supporting unit 300 includes a supporting plate 310 and a rotation driving member 330.

The supporting plate 310 has a circular plate shape. The supporting plate 310 may be made of graphite having a superior electrical conductivity. A plurality of first grooves 312 are formed along a circumferential direction in an edge region of an upper surface of the supporting plate 320. The first grooves 312 may be formed with a circular-shaped plane. In the present embodiment, while a case that the number of the first grooves 312 is six is exemplarily described, the number of the first grooves 312 may be greater than or less than 6. Centers of the first grooves may be positioned on the same circumference with respect to a center of the supporting plate 320.

A substrate holder 320 accommodating the substrate S is inserted and disposed in each of the first grooves 312. The substrate holder 320 may have a cylindrical shape of which an upper surface is opened. The substrate holder 320 may be made of graphite having a superior electrical conductivity. An outer diameter of the substrate holder 320 is smaller than a diameter of the first groove 312 such that a gap is provided between the substrate holder 320 and the first groove 312. An inner diameter of a sidewall of the substrate holder 320 is greater than a diameter of the substrate S. The substrate holder 320 rotates centering on a central axis thereof by a principle of a gas bearing, and the substrate S is rotated by rotation of the substrate holder 320. Spiral shaped grooves 313 are provided to a bottom surface of the first groove 312, and a gas is supplied to the spiral shaped grooves 313 from a gas supply member (not shown). The supplied gas flows along the spiral shaped grooves 313 to provide a rotational force to a lower surface of the substrate holder 320, and is discharged through a space between the substrate holder 320 and the first groove 312.

The rotation driving member 330 rotates the supporting plate 310. The rotation driving member 330 includes a driving shaft 332 and a driver 334. The driving shaft 332 penetrates the lower wall of the processing chamber 100 and may be insertedly installed, and is rotatably supported by a bearing 333. An upper end of the driving shaft 332 is connected to a lower surface of the supporting plate 310, and a lower end of the driving shaft 332 is connected to the driver 334. The driving shaft 332 delivers a driving force generated by the driver 334 to the supporting plate 310. The driver 334 may provide a rotational driving force for rotating the supporting plate 310 and a linear driving force for elevating and lowering the supporting plate 310. Unlike this, the driving shaft 332 and the driver 334 may be provided such that the driving shaft 332 and the driver 334 are positioned inside the processing chamber 100.

The heating unit 400 may be disposed below the supporting plate 310, and heats the substrate S supported by the supporting plate 310. As the heating unit 400, an RF heating means, for example, such as an RF coil may be used. The RF coil may be disposed on the same horizontal plane so as to enclose the driving shaft 332. When an electric power is supplied to the RF coil, the supporting plate 310 is inductively heated by the RF coil, and the heat of the supporting plate 310 is delivered to the substrate S through the substrate holder 320 and thus the substrate is heated to the process temperature.

The gas injection unit 500 is disposed spaced apart from the supporting plate 310 over a central region of the supporting plate 310, and injects reaction gases, i.e., a metal organic compound gas and a gas of hydrogen compound reacting with the metal organic compound gas to the substrates S supported by the supporting plate 310. The metal organic compound may be aluminum, gallium or indium compound, and the hydrogen compound may be arsene, phosphine or ammonia. The metal organic compound and the hydrogen compound are supplied to the gas injection unit 500 in a gas state together with a carrier gas. As the carrier gas, hydrogen, nitrogen or the like may be used.

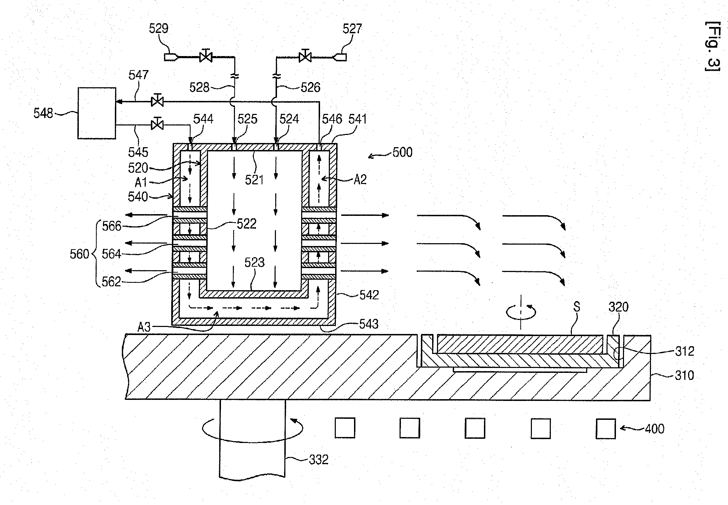

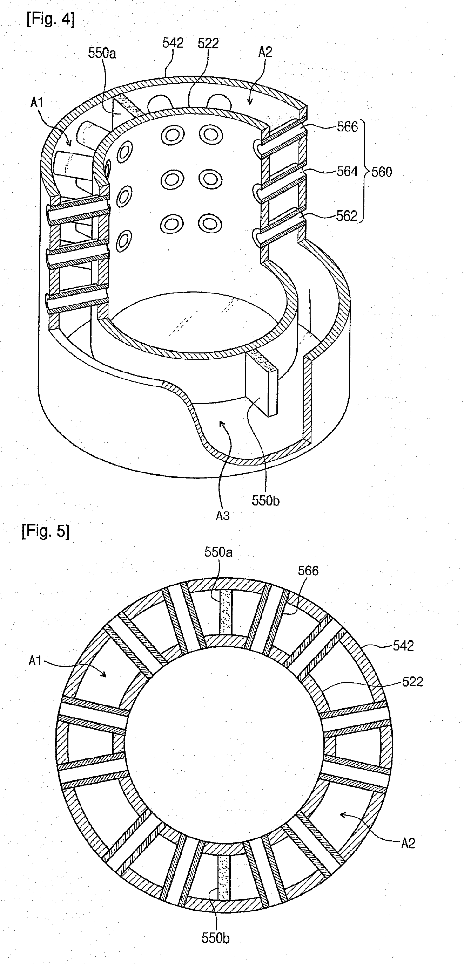

FIG. 3 is an enlarged view illustrating the gas injection unit and the substrate supporting unit of FIG. 1, FIG. 4 is a partial cutaway perspective view of a gas injection unit, and FIG. 5 is a plane sectional view of a gas injection unit.

Referring to FIGS. 3 through 5, the gas injection unit is aligned such that a length direction thereof is toward an up and down direction, and is disposed over the central region of the supporting plate 310. The gas injection unit 500 includes an inner pipe 520 through which a reaction gas is introduced, an outer pipe 540 enclosing the inner pipe 520, through which a cooling fluid cooling the reaction gas inside the inner pipe 520, and injection pipes 560 injecting the reaction gas inside the inner pipe 520 to an outside of the outer pipe 540.

In a related art, a gas injection member injecting reaction gases is exposed to a high temperature heat applied to the substrate and an unintended reaction occurs due to the high temperature heat before the reaction gases are supplied to the substrate, so that a parasitic deposition may occur on the gas injection member. However, since the gas injection unit 500 according to the embodiment of the present invention has the configuration that the outer pipe 540 is disposed to enclose the inner pipe 520 and the reaction gas supplied to the inner pipe 520 is cooled by the cooling fluid flowing through the outer pipe 540, the foregoing parasitic deposition can be overcome.

The inner pipe 520 may have a hollow cylindrical shape. That is, the inner pipe 520 may include an upper wall 521 having a circular plate shape, a sidewall 522 extending downwardly from the upper wall 521, and a lower wall 523 having a circular plate shape and coupled to a lower end of the sidewall 522. A first gas inlet port 524 and a second gas inlet port 525 are provided to the upper wall 521. A first gas supply line 526 supplying the gas of the metal organic compound is connected to the first gas inlet port 524, and a gas supply source 527 of the metal organic compound is connected to the other end of the first gas supply line 526. A second gas supply line 528 supplying the gas of the hydrogen compound is connected to the second gas inlet port 525, and a gas supply source 529 of the hydrogen compound is connected to the other end of the second gas supply line 528. The gas of the metal organic compound supplied through the first gas supply line 526 and the gas of the hydrogen compound supplied through the second gas supply line 528 are mixed with each other inside the inner pipe 520.

The outer pipe 540 encloses the inner pipe 520, and a cooling fluid cooling the reaction gas inside the inner pipe 520 flows through the outer pipe 540. The outer pipe 540 may have a hollow cylindrical shape. For example, the outer pipe 540 may have a ring-shaped upper wall 541, a sidewall 542 extending downwardly from an edge of the upper wall 541, and a lower wall having a circular plate shape and coupled to a lower end of the sidewall 542. An inner circumferential surface of the upper wall 541 is coupled to an edge of the upper wall 521 of the inner pipe 520, and the sidewall 542 and the lower wall 543 of the outer pipe 540 are provided spaced apart from the sidewall 522 and the lower wall 523 of the inner pipe 520.

A cooling fluid inlet port 544 is provided to one side of the upper wall 541 of the outer pipe 540, and a cooling fluid supply pipe 545 is connected to the cooling fluid inlet port 544. A cooling fluid outlet port 546 is provided to the other side of the upper wall 541 of the outer pipe 540, and a cooling fluid withdrawal pipe 547 is connected to the cooling fluid outlet port 546. End portions of the cooling fluid supply pipe 545 and the cooling fluid withdrawal pipe 547 are connected to a temperature controller 548. The cooling fluid the temperature of which is controlled by the temperature controller 548 is supplied to the outer pipe 540 through the cooling fluid supply pipe 545 and the cooling fluid inlet port 544. The cooling fluid flows through a space between the inner pipe 520 and the outer pipe 540 to cool the reaction gases supplied to the inside of the inner pipe 520. Thereafter, the cooling fluid is withdrawn to the temperature controller 548 through the cooling fluid outlet port 546 and the cooling fluid withdrawal pipe 547. The withdrawn cooling fluid is temperature-controlled and is again supplied to the outer pipe 540. As the cooling fluid, cooling water or an inert gas such as nitrogen gas may be used.

Separation plates 550a, 550b are provided to a space between the inner pipe 520 and the outer pipe 540. The separation plates 550a, 550b extend downwardly from the upper wall 541 of the outer pipe 540 such that a ring-shaped space between the inner pipe 520 and the outer pipe 540 is partitioned into a first region A1 fluidly communicating with the cooling fluid inlet port 544 and a second region A2 fluidly communicating with the cooling fluid outlet port 546. The first region A1 and the second region A2 fluidly communicate with each other through the lower wall 523 of the inner pipe 520 and the lower wall 543 of the outer pipe 540.

The injection pipes 560 connect the inner pipe 520 and the outer pipe 540 to inject the reaction gas inside the inner pipe 520 to an outside of the outer pipe 540. The injection pipes 560 may be provided in plurality along a circumferential direction of the inner pipe 520. For example, the injection pipes 560 may include a first group of injection pipes 562, a second group of injection pipes 564, and a third group of injection groups 566. The first group of injection pipes 562 may be provided in plurality along the circumferential direction of the inner pipe 520 at a height adjacent to the lower end of the sidewall 522 of the inner pipe 520. The second group of injection pipes 564 may be provided in plurality along the circumferential direction of the inner pipe 520 at a second height higher than the first height. The third group of injection pipes 566 may be provided in plurality along the circumferential direction of the inner pipe 520 at a third height higher than the second height.

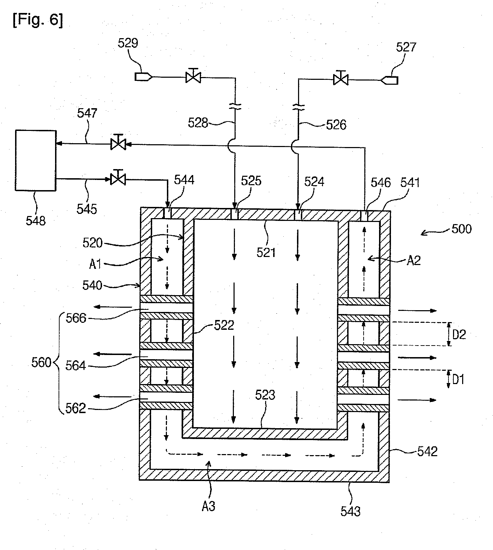

The first to third groups of injection pipes 562, 564, 566 may be provided at the same interval along the length direction of the inner pipe 520. Unlike this, the first to third groups of injection pipes 562, 564, 566 may be provided at different intervals (D2>D1) along the length direction of the inner pipe 520, as shown in FIG. 6. The first group of injection pipes 562 inject the reaction gas to a region adjacent to the supporting plate 310, and the third group of injection pipes 566 inject the reaction gas to a region adjacent to the upper wall 102 of the processing chamber 100 (see FIG. 1).

A process of depositing a metal layer on the substrate S using the thin layer deposition apparatus having the foregoing configuration will be described with reference to FIGS. 2 and 3.

After the substrate S is loaded on any one of the substrate holders 320, the substrates S are sequentially loaded on other substrate holders 320 while the supporting plate 310 rotates. When the loading of the substrates S are completed, the supporting plate 310 is rotated on the central axis thereof, and the substrates S are rotated by the substrate holder 320 being rotated on the central axis thereof by the gas bearing. The heating unit 400 heats the supporting plate 310 and thus the heat of the supporting plate 310 is delivered to the substrate S through the substrate holder 320, so that the substrate S is heated to the process temperature.

Thereafter, the gas of the metal organic compound is introduced into the inner pipe 520 through the first gas inlet port 524, and the gas of the hydrogen compound is introduced into the inner pipe 520 through the second gas inlet port 25. The gas of the metal organic compound and the gas of the hydrogen compound are mixed with each other inside the inner pipe 520.

At this time, the cooling fluid cooling the gas of the metal organic compound and the gas of the hydrogen compound inside the inner pipe 520 flows through the outer pipe 540. The temperature of the cooling fluid is controlled by the temperature controller 548, and the temperature-controlled cooling fluid continues to be circulated through the cooling fluid supply pipe 545, the cooling fluid inlet port 544, the outer pipe 540, the cooling fluid outlet port 546, and the cooling fluid withdrawal pipe 547. Since the gas of the metal organic compound and the gas of the hydrogen compound inside the inner pipe 520 are cooled by the cooling fluid, it can be prevented that the gas of the metal organic compound and the gas of the hydrogen compound react with each other before being injected onto the substrate S.

After the gas of the metal organic compound and the gas of the hydrogen compound are mixed and cooled inside the inner pipe 520, the gas of the metal organic compound and the gas of the hydrogen compound are injected to the substrate S through the injection pipes 560 connecting the inner pipe 520 and the outer pipe 540. Since the injection pipes 560 are provided along the circumferential direction of the inner pipe 520, the gas of the metal organic compound and the gas of the hydrogen compound may be uniformly injected onto the substrates S loaded on the supporting plate 310 in the circumferential direction. The gas of the metal organic compound and the gas of the hydrogen compound injected onto the substrates S are decomposed by a high temperature heat applied to the substrates S to deposit a thin metal layer.

### [Industrial Applicability]

Hereinafter, other examples of the substrate supporting unit and the gas injection unit will be described.

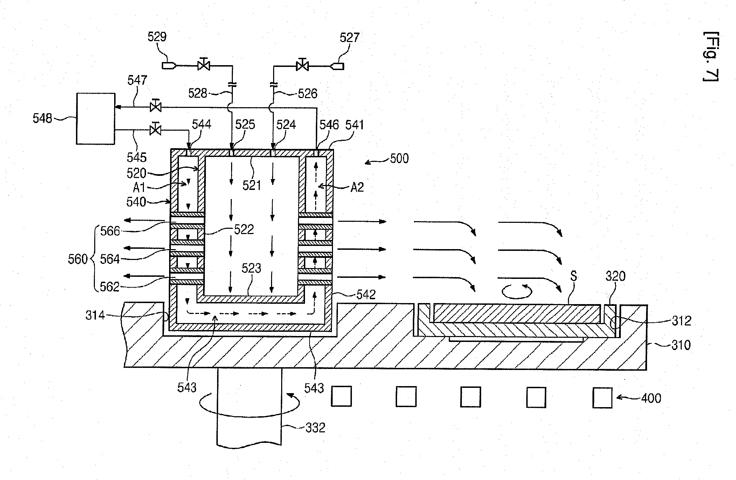

FIG. 7 is a schematic view illustrating another layout structure of the gas injection unit and the substrate supporting unit. Referring to FIG. 7, a second groove 314 is formed in a central region of the supporting plate 310, and an outer pipe 540 of the gas injection unit 500 is inserted into the second groove 314 such that the outer pipe 450 is disposed spaced apart from a bottom surface of the second groove 314. By the above configuration, since the distance in the up and down direction between the injection pipes 560 and the supporting plate 310 is shortened, the injection pipes 560 can inject the reaction gases onto the substrates S more uniformly to thus deposit a high quality thin metal layer.

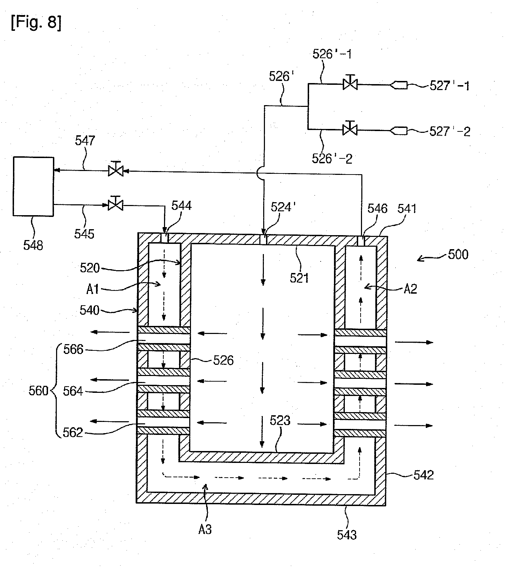

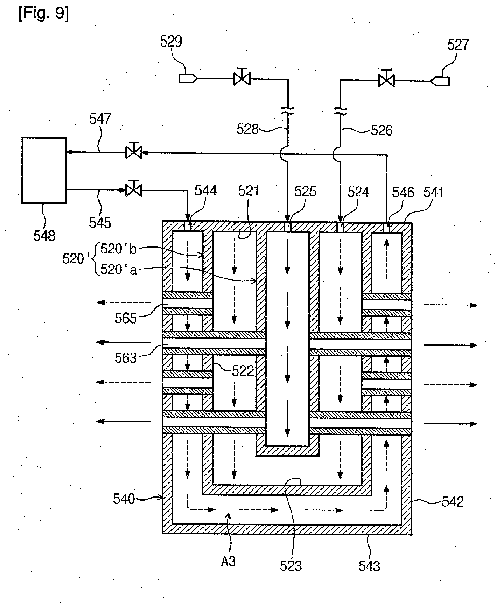

FIGS. 8 and 9 are schematic views illustrating still another embodiment of the gas injection unit of FIG. 3. Like reference numerals in the drawings of FIGS. 3 and 8, 9 denote like elements, and thus their description will be omitted. Hereinafter, only a difference between the gas injection unit of FIG. 3 and the gas injection units of FIGS. 8 and 9 will be described.

Referring to FIG. 8, a single gas inlet port 524' is provided to an inner tube 520. A main gas supply pipe 526' is connected to the gas inlet port 524', and the main gas supply pipe 526' is branched into a first branch pipe 526'-1 and a second branch pipe 526'-2. A first gas supply source 527'-1 supplying a gas of metal organic compound is connected to the first branch pipe 526'-1, and a second gas supply source 527'-2 supplying a gas of hydrogen compound is connected to the second branch pipe 526'-2. The gas of the metal organic compound and the gas of the hydrogen compound are mixed in a main gas supply pipe 526' and are then supplied to the gas inlet port 524' of the inner pipe 520.

Referring to FIG. 9, an inner pipe 520' includes a first inner pipe 520'a, and a second inner pipe 520'b enclosing the first inner pipe 520'a. A second gas inlet port 525 is provided to the first inner pipe 520'a, and the gas of the hydrogen compound is supplied to an inside of the first inner pipe 520'a through the second gas inlet port 525. A first gas inlet port 524 is provided to the second inner pipe 520'b, and the gas of the metal organic compound is supplied to an inside of the second inner pipe 520'b through the first gas inlet port 524. Since the gas of the metal organic compound and the gas of the hydrogen compound are supplied to the first inner pipe 520'a and the second inner pipe 520'b having an independent space, the gas of the metal organic compound and the gas of the hydrogen compound are maintained in a state that the gas of the metal organic compound and the gas of the hydrogen compound are not mixed with each other. First injection pipes 563 connect the first inner pipe 520'a and an outer pipe 540 to inject the gas of the hydrogen compound inside the first inner pipe 520'a to an outside of the outer pipe 540. Second injection pipes 565 connect the second inner pipe 520'b and the outer pipe 540 to inject the gas of the metal organic compound inside the second inner pipe 520'b to an outside of the outer pipe 540.

According to the present invention, since the reaction gases inside the inner pipe of the gas injection unit can be cooled to a temperature lower than the reaction temperature, an unintended reaction of the reaction gases can be prevented in advance.

Also, the quality of a thin metal layer deposited can be enhanced.

The above-disclosed subject matter is to be considered illustrative and not restrictive, and the appended claims are intended to cover all such modifications, enhancements, and other embodiments, which fall within the true spirit and scope of the inventive concept. Thus, to the maximum extent allowed by law, the scope of the inventive concept is to be determined by the broadest permissible interpretation of the following claims and their equivalents, and shall not be restricted or limited by the foregoing detailed description.

## Claims

1. An apparatus for depositing a thin layer, comprising:
a processing chamber;
a substrate supporting unit disposed in the processing chamber to support the substrate;
a heater heating the substrate supported by the substrate supporting unit; and
a gas injection unit disposed over the substrate supporting unit in the processing chamber,
wherein the gas injection unit comprises:
an inner pipe through which a reaction gas is introduced;
an outer pipe enclosing the inner pipe, through which a cooling fluid cooling the reaction gas in the inner pipe flows; and
injection pipes injecting the reaction gas in the inner pipe to an outside of the outer pipe.

2. The apparatus of claim 1, wherein the gas injection unit is disposed such that the length direction of the inner pipe and the outer pipe are toward an up and down direction.

3. The apparatus of claim 2, wherein the substrate supporting unit comprises:
a supporting plate having a plate shape and formed with a plurality of first grooves accommodating a substrate holder in an edge region of an upper surface thereof along a circumferential direction; and
a rotation driving member rotating the supporting plate,
wherein the gas injection unit is disposed over a central region of the supporting plate.

4. The apparatus of claim 3, wherein the supporting plate is formed with a second groove in the central region of the upper surface of the supporting plate, and the outer pipe is inserted into the second groove such that a lower end of the outer pipe is disposed spaced apart from a bottom surface of the second groove.

5. The apparatus of claim 3, wherein the injection pipes are provided in plurality along a circumferential direction of the inner pipe.

6. The apparatus of claim 5, wherein some of the injection pipes are provided at heights different from each other.

7. The apparatus of claim 5, wherein the injection pipes are divided into a plurality of groups,
the injection pipes which pertain to the same group are provided at the same height of the inner pipe along the circumferential direction, and
the injection pipes which pertain to different groups are provided at different heights of the inner pipe along the circumferential direction.

8. The apparatus of claim 7, wherein the injection pipes which pertain to any one group of the plurality of groups are provided to inject the reaction gas to a region adjacent to the supporting plate, and
the injection pipes which pertain to another group of the plurality of groups are provided to inject the reaction gas to a region adjacent to an upper wall of the processing chamber.

9. The apparatus of any one of claims 1 to 3, wherein the gas injection unit further comprises:
a first gas inlet port provided to the inner pipe such that a first reaction gas is introduced; and
a second gas inlet port provided to the inner pipe such that a second reaction gas is introduced.

10. The apparatus of any one of claims 1 to 3, wherein the gas injection unit comprises:
one gas inlet portion provided to the inner pipe;
a main gas supply pipe connected to the gas inlet port;
a first gas supply source connected to a first branch pipe branched from the main gas supply pipe to supply a first reaction gas; and
a second gas supply source connected to a second branch pipe branched from the main gas supply pipe to supply a second reaction gas.

11. The apparatus of any one of claims 1 to 3, wherein the gas injection unit comprises:
a cooling fluid inlet port provided to the outer pipe such that the cooling fluid is introduced; and
a cooling fluid outlet port provided to the outer pipe such that the cooling fluid is discharged.

12. The apparatus of claim 11, wherein the gas injection unit further comprises a separation plate which partitions a space between the inner pipe and the outer pipe into a first region fluidly communicating with the cooling fluid inlet port, a second region fluidly communicating with the cooling fluid outlet port, and a third region fluidly communicating the first region and the second region with each other.

13. The apparatus of claim 3, wherein the inner pipe comprises:
a first inner pipe through which a first reaction gas is introduced; and
a second inner pipe enclosing the first inner pipe, through which a second reaction gas is introduced,
wherein the injection pipes comprise:
first injection pipes injecting the first reaction gas inside the first inner pipe to an outside of the outer pipe; and
second injection pipes injecting the second reaction gas inside the second inner pipe to the outside of the outer pipe.

14. The apparatus of claim 13, wherein the injection pipes comprise:
a cooling fluid inlet port provided to the outer pipe such that the cooling fluid is introduced; and
a cooling fluid outlet port provided to the outer pipe such that the cooling fluid is discharged.

15. The apparatus of claim 14, wherein the gas injection unit further comprises a separation plate which partitions a space between the outer pipe and the second inner pipe into a first region fluidly communicating with the cooling fluid inlet port, a second region fluidly communicating with the cooling fluid outlet port, and a third region fluidly communicating the first region and the second region with each other.

16. A method for depositing a thin layer, comprising:
loading a substrate into a processing chamber;
heating the substrate; and
injecting a reaction gas onto the substrate,
wherein the reaction gas is introduced into an inner pipe of a gas injection unit, is cooled by a cooling fluid flowing through an outer pipe enclosing the inner pipe, and is injected onto the substrate through injection pipes connecting the inner pipe and the outer pipe.

17. The method of claim 16, wherein the gas injection unit is disposed such that the length direction thereof is toward an up and down direction, and the reaction gas is injected onto the substrate through the injection pipes disposed in a horizontal direction.

18. The method of claim 17, wherein the substrate loaded is in plurality, the plurality of substrates are loaded on an edge region of a supporting plate in a circumferential direction, and the gas injection unit injects the reaction gas over a central region of the supporting plate.

19. The method of claim 18, wherein the supporting plate rotates a central axis thereof, and each of the plurality of substrates rotates on a central axis there.

20. The method of claim 19, wherein the reaction gas comprises a first reaction gas and a second reaction gas having a component different from the first reaction gas,
wherein the first and second reaction gases are independently introduced into the inner pipe and are then mixed with each other.

21. The method of claim 19, wherein the reaction gas comprises a first reaction gas and a second reaction gas having a component different from the first reaction gas,
wherein the first and second reaction gases are introduced into the inner pipe in a mixed state.

22. The method of claim 19, wherein the reaction gas comprises a first reaction gas and a second reaction gas having a component different from the first reaction gas,
the inner pipe comprises a first inner pipe through which the first reaction gas is introduced, and a second inner pipe enclosing the first inner pipe, through which the second reaction gas is introduced, and
the first reaction gas is injected through first injection pipes connecting the first inner pipe and the outer pipe, and the second reaction gas is injected through second injection pipes connecting the second inner pipe and the outer pipe.

23. A gas injection unit comprising:
an inner pipe through which a reaction gas is introduced;
an outer pipe enclosing the inner pipe, through which a cooling fluid cooling the reaction gas inside the inner pipe flows; and
injection pipes injecting the reaction gas inside the inner pipe to an outside of the outer pipe.

24. The gas injection unit of claim 23, wherein the injection pipes are provided in plurality along a circumferential direction of the inner pipe,
the injection pipes are divided into a plurality of groups,
the injection pipes which pertain to the same group are provided at the same height of the inner pipe along the circumferential direction, and
the injection pipes which pertain to different groups are provided at different heights of the inner pipe along the circumferential direction.

25. The gas injection unit of claim 24, further comprising:
a first gas inlet port provided to the inner pipe such that the first reaction gas is introduced; and
a second gas inlet port provided to the inner pipe such that the second reaction gas is introduced.
